# EUROPEAN PATENT APPLICATION

(11) **EP 1 612 567 A2**
(43) Date of publication of application: **04.01.2006**
(21) Application number: 05013051.7
(22) Date of filing: 16.06.2005
(51) Int. Cl.: G01R 21/12

(54) **A partial discharge sensing device for a gas insulated apparatus**

(30) Priority: 29.06.2004 JP 2004190832
(71) Applicant: Japan AE Power Systems Corporation, Tokyo 105-0003 (JP)
(72) Inventor: Shinohara, Ryoichi Japan AE Power Systems Corp., Hitachi-shi Ibaraki 316-8501 (JP); Kato, Tatsuro Hitachi Ltd., Int. Prop. Group, Chiyoda-ku Tokyo 100-8220 (JP)
(74) Representative: Strehl Schübel-Hopf & Partner

(57) **Abstract**

A thin film (11) detection electrode (10) is formed on an insulating substrate (13). The resulting detection electrodes (10) are light-weight, and have a very high dimensional accuracy so that the number of the parts supporting the detection electrodes (10) is small and the size of the detection electrodes (10) becomes very small. By an increase in the dimensional accuracy of the detection electrodes (10), reduction in insulating properties due to a water content in a insulating gas can be measured in addition to measurement of electromagnetic wave.

## Description

### Field of the invention:

The present invention relates to a partial discharge detecting sensor, a partial discharge detecting device and a gas insulated electric apparatus that uses an insulating gas such as sulfur hexa-fluoride (SF₆), etc, and more particularly to a gas insulated electric apparatus having a partial discharge detecting sensor. Further, the present invention relates to a discharge detecting device and a partial discharge detecting sensor.

Gas insulated electric apparatuses of the present invention include gas insulated switchgears, gas insulated buses, gas insulated transformers, etc. A system or switchgear including the gas insulated devices comprises the gas insulated electric devices and gas insulated buses having conductors supported in metallic containers or tubes, wherein the conductors are connected with the gas insulated electric devices.

### Related Art:

The gas insulated electric apparatuses such as gas insulated switchgears, gas insulated buses, gas insulated transformers, etc have a metallic container which is filled with an insulating gas such as SF₆ gas and a high voltage conductor is insulatively supported in the container. These gas insulated electric apparatuses may bring about partial discharge due to entering of metallic particles into the container, projection formed on the high voltage conductors, interior failure such as voids formed in insulating supports thereby to lower insulation characteristics, which may lead to insulation breakdown.

In order to prevent the insulation breakdown in advance, it is necessary to detect the partial discharge with high accuracy, which is a precursor phenomenon of insulation breakdown.

One method for detecting the partial discharge with a high accuracy is to detect electromagnetic wave caused by partial discharge. In the method, which has been well known, there is provided a metallic detection electrode to a hand hole in the metallic container to detect the electromagnetic wave as shown in patent documents Nos. 1 and 2.

In this electromagnetic wave detection method, signals detected by a detection sensor are subjected to frequency analysis over a frequency range of several hundreds MHz to several GHz by means of a spectrum analyzer to measure frequency-signal intensity characteristics. As a result, the presence of partial discharge signals in the frequency range of several hundreds MHz to several GHz is confirmed.

In another method, signals detected by the sensor that have been passed through a band path filter for several hundreds MHz to several GHz are subjected to envelope detection to detect signals. Thus, the presence of partial discharge based on voltage phase angle-signal intensity characteristics is confirmed.

### Patent document No. 1: Japanese patent laid-open No. 08-271574 (refer to Abstract)

### Patent document No. 2: Japanese patent No. 3,299,547

In the electromagnetic wave detection methods, it is general that detection electrodes are disposed to electric apparatuses such as gas insulated electric apparatuses, circuit breakers, etc which generate large vibration at the time of operation or from which decomposition products from SF₆ are generated. In these cases, since the detection electrodes are made of metal plates made of, such as, stainless steel or aluminum, etc, a thickness of the electrodes becomes large when a mechanical strength of the electrodes is secured to withstand the vibration. Further, fitting members for the sensors becomes large and heavy; as a result, a volume of the sensors becomes large. Still further, the number of parts for fitting the sensors increases; there may be fluctuation in characteristics by virtue of dimension differences, which leads to decrease in the detection accuracy.

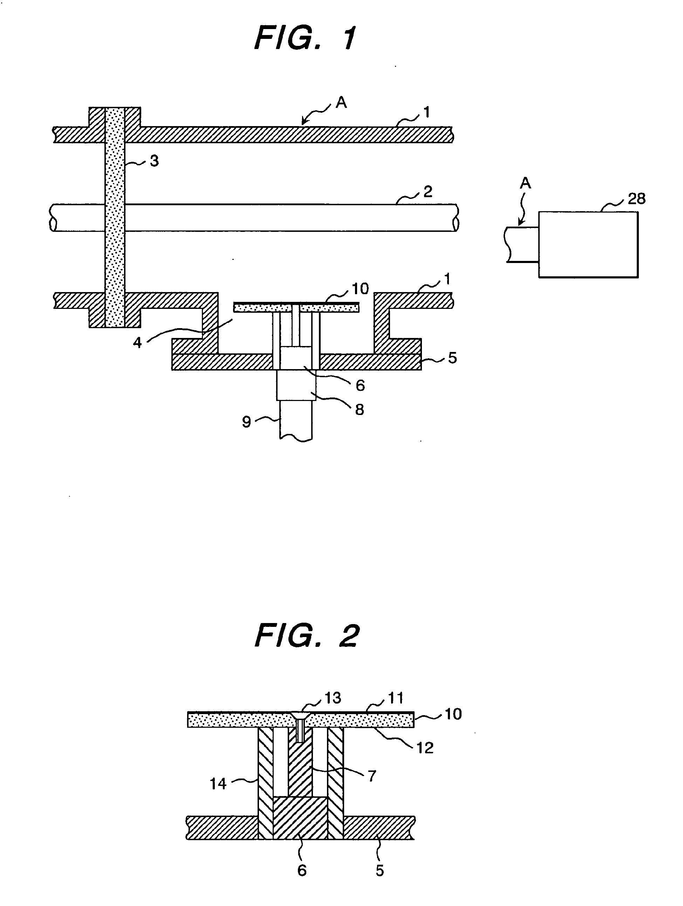

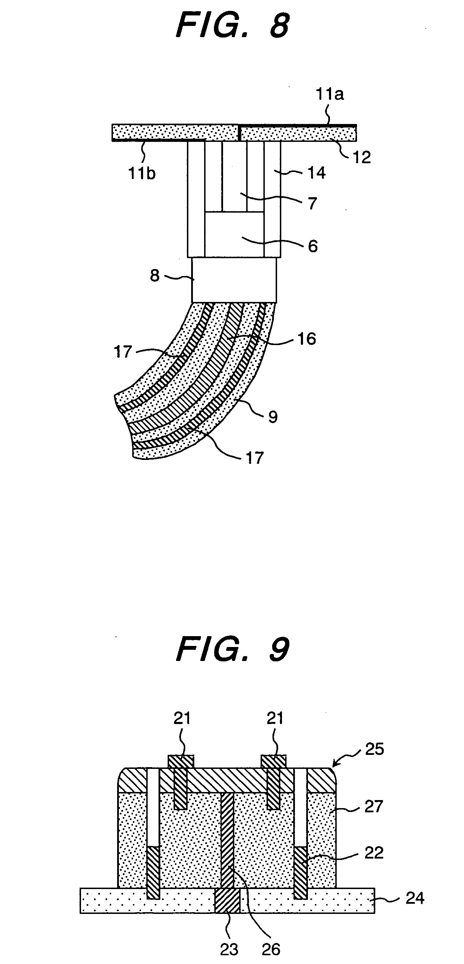

In the case of the detection sensor disclosed in patent document No. 2, the metallic electrode 4 in Fig. 1 should have a thickness of at least 2 or 3 mm so as to keep flatness of the electrode. If the electrode is too thin, it is difficult to keep its surface flat. Further, if the electrode is too thin, machined edges of the electrode may be deformed curled, whereby discharge at the edges take place. The electrode should have a certain thickness such as 2 to 3 mm so that a sectional view of its peripheral edge can be machined round thereby to prevent discharge at the peripheral edge. As a result, the metallic electrode plate 4 must be fixed to an insulating support 6 by means of several thick bolts and the insulating support 6 must be fixed by means of several thick bolts to a flange 5 of a hand hole as shown in Fig. 9. Therefore, the structure of the sensor comprising the metallic plate 4, insulating support 6 and the flange 5 becomes very large and heavy.

### Summary of the invention:

An object of the present invention is to provide a partial discharge detecting sensor with a reduced weight and with a simplified structure.

A partial discharge detecting sensor (1) according to the present invention comprises an electro-conductive thin film having a preferable thickness of 500 µm or less, an insulating substrate to which the film is bonded or adhered, a terminal, electrically connected to the film, for transmitting signals detected by the thin film electrode and a base or a flange for supporting the substrate. The sensor is disposed in a recess of a hand hole of a gas insulated bus having a conductor. The gas insulated bus is connected with at least one of gas insulated electric devices.

A partial discharge detecting device (2) according to the present invention comprises the partial discharge detecting sensor (1) mentioned-above and a coaxial cable connected by means of a connector to the terminal. The coaxial cable may be always connected to the terminal, or is connected if the partial discharge detection test is conducted. The coaxial cable is connected to a measuring device or a spectrum analyzer. The sensor part of the partial discharge detecting device (2) is disposed in the recess of the hand hole of the gas insulated bus having a conductor and a gas insulated switch connected with the gas insulated bus.

A gas insulated electric apparatus according to the present invention comprises the partial discharge detecting sensor (1) or the partial discharge detecting device (2), a gas insulated bus having the conductor therein having the hand hole disposed in a recess formed in the hand hole, a gas insulated switch connected to the bus.

### Brief description of the drawings:

Fig. 1 is a front view of a gas insulated electric apparatus including a partial discharge detection device.
Fig. 2 is a cross sectional view of the detection sensor shown in Fig. 1.
Fig. 3 is a side view of the gas insulated electric apparatus shown in Fig. 1.
Fig. 4 is a perspective view showing a shape of the detection electrode in one embodiment of the present invention.
Fig. 5 is a perspective view showing a shape of the detection electrode in another embodiment of the present invention.
Fig. 6 is a cross sectional view of a detection electrode of another embodiment.
Fig. 7 is a cross sectional view showing a detection electrode having plural metal films.
Fig. 8 is a cross sectional view of a detection electrode having metal films on both faces of an insulating substrate.
Fig. 9 is a cross sectional view of a partial discharge detecting sensor disclosed in patent document No. 2.

### (Explanation of reference numerals)

1; metallic container, 2; high voltage conductor, 3; insulating supporter, 4; hand hole, 5; cover, 6; seal terminal, 7; conductor, 8; connector, 9; coaxial cable, 10; detection electrode, 11; metal film, 12; insulating substrate, 13; screw, 14; electrode supporter, 15; protecting coat, 16; core wire, 17; outer wire, 20; plate electrode, 21, 22; bolts, 23; terminal, 24; flange, 25; periphery edge, 27; insulating support, 28; gas insulated electric device.

### Description of preferred embodiments;

The present invention is characterized in that in a gas insulated electric apparatus having a high voltage conductor supported by means of an insulating supporter in a metallic container filled with an insulating gas, an insulating failure detection electrode having an electrode pattern formed on a surface of an insulating substrate is disposed in the metallic container, and signals detected by the detection electrode are measured through a coaxial cable by a measuring device disposed outside of the metallic container.

According to the present invention, since the detection electrode can be made lighter than the conventional one so that fitting members for the electrode can be downsized. Since the electrode is fixed, the number of the fitting members is small.

Metallic materials for the thin metal film to be formed on a substrate includes good electrical- thermal conductive metals such as copper, silver, aluminum, etc.

A thickness of the metal films may be 10 to 1000 µm, more preferably 20 to 100 µm,

Insulating substrates for supporting the metal films are polymeric materials such as epoxy resin, polyimide resin, etc. The resins may be reinforced with fibrous material such as glass fibers. The resins may contain various filler materials to strengthen the substrate.

The substrate should be self-supporting and can withstand vibration in the gas insulated apparatus. A thickness of the substrate made of resin materials should preferably be 0.5 to 5 mm, more preferably 1 to 3 mm. On the other hand, if the substrate is made of ceramics such as alumina, aluminum nitride, zirconia, insulating silicon carbide, etc, a thickness of the substrate may be 0.5 to 5 mm, preferably 1 to 3 mm.

In the following, embodiments of the present invention will be explained by reference to drawings.

Fig. 9 shows a concrete structure of the partial discharge detection device shown in Fig. 2. The metallic electrode plate 20 is fixed by bolts (at least 4 bolts) to the insulating supporter 27. The insulating supporter 27 is fixed to a flange 24 by means of bolts (at least 4). The peripheral edge 25 of the electrode plate is machined to make the peripheral edge round so that breakdown at the periphery is prevented. Accordingly, the electrode plate must have a thickness at least several mm. In patent document No. 1, a disc plate 10 has a thickness of 2 mm, for example. Therefore, the disc 10 must be fixed by means of bolts, etc.

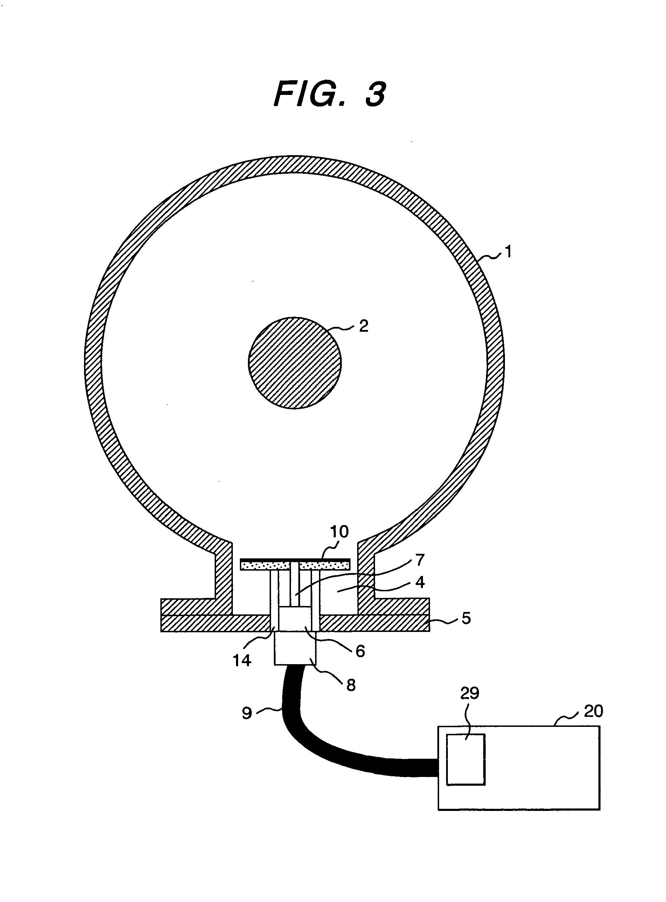

Fig. 1 shows a cross sectional front view of a gas insulated electric apparatus embodying a detection electrode the present invention. Fig. 3 is a side sectional view of the gas insulated electric apparatus shown in Fig. 1. Although a measurement device is omitted in Fig. 1, the measurement device is shown in Fig. 3. Fig. 2 shows an enlarged view of a detection sensor.

The embodiment shown in Figs. 1 and 3 show the case where the insulation failure detection device is applied to one phase of the gas insulated buses of the gas insulated electric apparatus. In this embodiment, the metallic container is a tube form, which is grounded. The metallic container is filled with an insulating gas such as SF6; a high voltage conductor 2 is supported insulatively by means of an insulating supporting member 3 made of an insulating material such as epoxy resin in the container.

A hand hole 4 is disposed to the metallic container 1, wherein a detection sensor having the detection electrode 10 is disposed. The detection sensor comprises the detection electrode 10, a conductor 7 for transmitting signals detected by the electrode and a sealing terminal 6 that permeates a cover 5 for sealing the hand hole 4.

The detection electrode 10 is constituted by a metal film 11 formed on an insulating substrate 12. The detection electrode 10 can be prepared by etching a printed board to form a metal pattern. As another method, a metal film is formed by a vacuum vapor deposition method on an insulating substrate, or a conductive paint is coated in a electrode pattern on an insulating substrate. When the printed circuit board is used, the electrode pattern can be made at a high accuracy. When the electrode pattern is prepared by the vacuum vapor deposition method, there is almost no difference in detection sensitivity of the sensors; it is possible to simplify quality control of the sensors.

A suitable material for the metal film 11 may be copper or aluminum, which is good in electric conductivity; a preferable thickness of the film may be 20 to 30 µm; the thickness should not exceed 500µm. In the conventional metal plates, a thickness was 2 to 3 mm. Thus, the electrode could be light-weighted very much.

If the electrode pattern of the detection electrode is formed on the insulating substrate, the weight of the electrode is greatly reduced; thus a supporting structure for the electrode can be greatly simplified. For example, as shown in Fig. 2, the insulating substrate 12 can be fastened to the conductor 7 simply by screwing a screw 13. If the electrode is fixed more firmly, a electrode supporting member 14 made of an insulating material may be disposed. The detection electrode 10 is fixed to the conductor 7 by soldering, without using the screw.

When a metal plate having a thickness of several mm, as in the conventional technology, it is necessary to use a large sized supporting member or a large sized antenna supporting member. However, the present invention greatly reduces the number of fitting members. Fluctuations of sensitivity of the sensors due to fluctuations of dimensions in manufacturing or forming plate electrodes in the conventional technology can be reduced by the present invention. In addition to the above advantages, downsizing the detection sensors with lightweight can be achieved, which leads to detection sensors of a low price.

As having discussed above, the detection electrode 10 is electrically connected to the conductor 7 connected to the sealing terminal 6 penetrating the cover 5 of the hand hole 4. The sealing terminal 6 is further connected to a connector 8, which is electrically connected to a coaxial cable 9 connected to a measurement device 20. The detection electrode 10 is electrically insulated from the metallic container 1. The detection sensor, the connector 8, the coaxial cable 9 and the measurement device 20 constitute the insulation failure detection apparatus according to the present invention.

The detection sensor according to the present invention is disposed not only to the hand hole 4 in the gas insulated electric apparatus in this embodiment, but to other positions than the hand hole or outside of the apparatus.

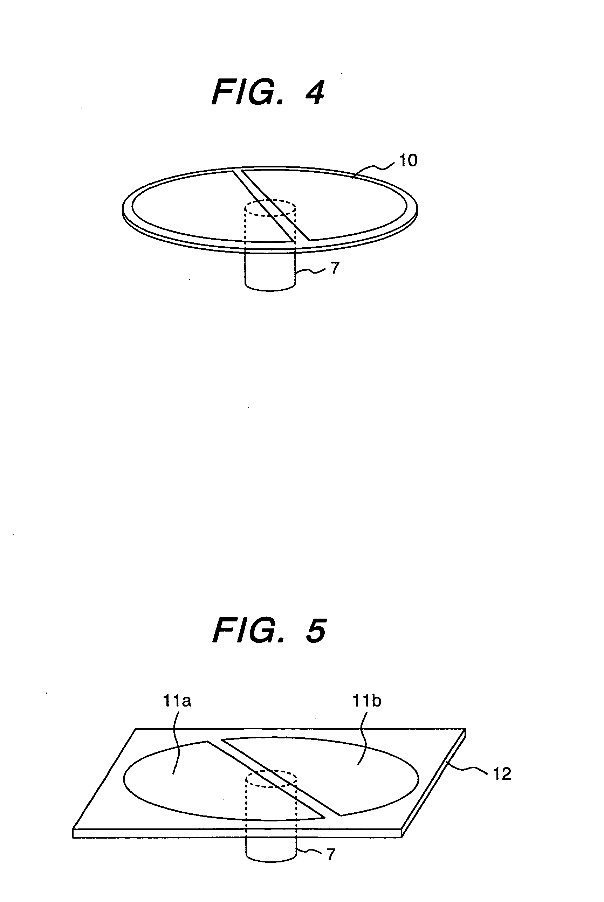

A shape of the detection electrode may be a disc form such as shown in Fig. 4 where a metal film is formed by vapor deposition on a insulating disc, an electro-conductive coating on the insulating disc, or a circular metal film on a rectangular insulating substrate as shown in Fig. 5.

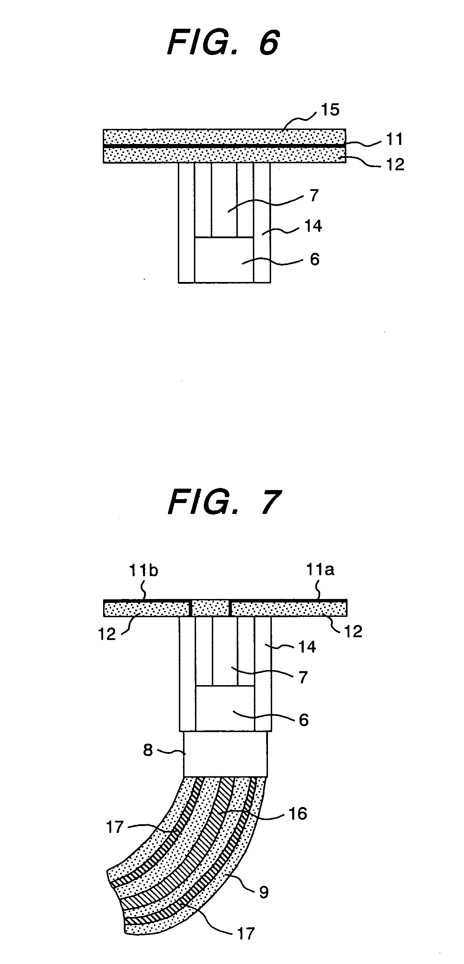

When the detection sensor according to the present invention is employed for switches such as a circuit breaker or a disconnector, there may be possibility of corrosion in the detection electrode by decomposition product gases from SF6. In such case, a protecting coating 15 is formed on the metal film 11 as shown in Fig. 6. The protecting coating 15 is formed by coating an insulating material or laminating an insulating thin plate.

If a partial discharge takes place in the metallic container 1, high frequency current pulses of about several GHz generate and propagate through the metallic container. When the propagated electromagnetic waves are detected by the metal film 11, which is a detection antenna, a voltage is induced in the metal film 11. The induced voltage is taken out by means of the conductor 7 and the seal terminal 6 to be transmitted through the coaxial cable 9 to the measurement device 20. By transmitting the signals from the antenna through the coaxial cable, signals of frequency of 1000 MHz or higher can be transmitted to the measurement device without decaying.

As a detection electrode, plural metal films that are not electrically connected to each other are formed on an insulating substrate as shown in Figs. 7 and 8, whereby antenna characteristics may be further improved. In these cases, one metal film 11a having an electrode pattern is electrically connected to an core wire 16 of the coaxial cable 9, and the other metal film 11b is electrically connected to an outer layer wire 17 of the coaxial cable 9.

As shown in Fig. 8, if the metal films having electrode patterns are formed on both faces of the insulating substrate 12, it is possible to further improve insulating properties between the electrodes and detection sensitivity. The electrodes on both faces may be electrically connected. In the coaxial cable, the core wire and the outer wire are covered with insulating layers.

According to the present invention, it is possible to increase a dimensional accuracy of detection electrodes; therefore, the electrodes can be used to measure a partial discharge and to detect lowering of insulation of a gas insulated electric apparatus. In the gas insulated electric apparatus, insulating properties may be lowered by water in the insulating gas or decomposition products from the insulating gas.

In the case of the conventional metal plate electrodes, since there may be fluctuations in electric properties such as insulating resistance between the detection electrodes of detection sensors, precise measurement was difficult. Therefore, the plate electrodes could not be used if measuring the lowering of insulating properties. Accordingly, in the conventional technology, a small amount of insulating gas in the metallic container is taken out to chemically analyze the components in the gas or a water content in the gas is analyzed by a water content analyzer or a dew point meter.

In the present invention, however, since detection electrodes with high dimensional accuracy are manufactured, they can be used to measure the reduction in insulating properties. The measurement of the reduction in insulating properties according to the present invention is practiced by applying voltage between the electrodes, as shown in Fig. 7, to measure a leak current flowing between the electrodes.

According to the present invention, it is possible to conduct insulation failure monitoring with one sensor on partial discharge by measuring electromagnetic wave and on reduction in insulating properties caused by water in the insulating gas.

According to the present invention, it is possible to make lighter the detection electrode used for partial discharge of the gas insulated electric apparatus, and the number of the parts for supporting the electrode can be reduced.

## Claims

1. A sensor for detecting insulation failure comprising an electrode film, formed on an insulating substrate, for detecting insulation failure, a conductor electrically connected to the electrode and a terminal, wherein the electrode film is bonded or adhered to the insulating substrate.

2. The sensor for detecting insulation failure according to claim 1, wherein the film comprises two electrode patterns formed on the insulating substrate.

3. The sensor for detecting insulation failure according to claim 1 or 2, wherein one of the electrode patterns is formed on one surface of the substrate and the other is formed on the other face of the substrate.

4. The sensor for detecting insulation failure according to any of claims 1 to 3, wherein the film has a thickness less than 5 mm

5. The sensor for detecting insulation failure according to any of claims 1 to 4, wherein the electrode pattern for detecting insulation failure is prepared by etching a printed circuit board.

6. The sensor according to any of claims 1 to 5, wherein the surface where the electrode pattern is formed is covered with a protecting coat.

7. An insulation failure detection device comprising the sensor according to any of claims 1 to 6, a co-axial cable for transmitting electric signals detected by the electrode, and a measuring device for measuring the electric signals transmitted though the cable.

8. The insulation failure detection device according to claim 7, wherein electromagnetic wave generated upon partial discharge is detected by the electrode pattern, and a voltage induced by the electromagnetic wave is measured by the measuring device.

9. The insulation failure detection device according to claim 7 or 8, wherein a leak current flowing between the two electrode patterns is measured to detect insulation failure.

10. A gas insulated electric apparatus including a metallic container filled with an insulating gas, a high voltage conductor supported by an insulator in the container, and the insulation failure detection device according to any of claims 7 to 9.

11. The gas insulated electric apparatus according to any of claims 7 to 10, wherein electromagnetic wave generated by partial discharge is received by the electrode pattern, thereby to induce a voltage upon receiving the electromagnetic wave, the induced voltage being measured by the measuring device.

12. The gas insulated electric apparatus according to any of claims 7 to 11, wherein a leak current flowing between the two patterns is measured to detect the insulation failure.
